(19) Europäisches Patentamt

European Patent Office

Office européen des brevets

(11) **EP 1 645 028 B1**

(12) **EUROPEAN PATENT SPECIFICATION**

(45) Date of publication and mention of the grant of the patent:
**19.12.2018 Bulletin 2018/51**

(51) Int Cl.:
***H03F 1/32*** *(2006.01)*

(21) Application number: **04737911.0**

(22) Date of filing: **30.06.2004**

(86) International application number:
**PCT/CA2004/000972**

(87) International publication number:
**WO 2005/004323 (13.01.2005 Gazette 2005/02)**

(54) **ADAPTIVE PREDISTORTION FOR A TRANSMIT SYSTEM**

ADAPTIVE VORVERZERRUNG FÜR EIN SENDESYSTEM

PRE-DISTORSION ADAPTIVE POUR SYSTEME DE TRANSMISSION

(84) Designated Contracting States:
**AT BE BG CH CY CZ DE DK EE ES FI FR GB GR HU IE IT LI LU MC NL PL PT RO SE SI SK TR**

(30) Priority: **03.07.2003 US 613856**
**03.07.2003 US 613372**
**03.07.2003 US 613355**

(43) Date of publication of application:
**12.04.2006 Bulletin 2006/15**

(73) Proprietor: **Zarbaña Digital Fund, LLC**
**New Castle County, DE 19808 (US)**

(72) Inventors:
• **SAED, Aryan**
**Ottawa, Ontario K2B 7Y8 (CA)**
• **GUILLEMETTE, Phil**
**Ottawa, Ontario K1S 5L5 (CA)**

(74) Representative: **Carpmaels & Ransford LLP**
**One Southampton Row**
**London WC1B 5HA (GB)**

(56) References cited:
**EP-A- 0 930 699    EP-A- 1 170 858**
**WO-A1-01/08294    US-A- 6 075 412**
**US-B1- 6 246 286**

**Description**

FIELD OF THE INVENTION

The present invention relates generally to power amplification systems and is specifically applicable but not limited to power amplification systems using a Chireix architecture.

BACKGROUND OF THE INVENTION

The recent revolution in communications has caused a renewed focus on wireless technology based products. Mobile telephones, handheld computers, and other devices now seamlessly communicate using wireless technology. One component that forms the core of such technology is the amplifier. Wireless devices require high efficiency amplifiers to not only extend the range of their coverage but also to conserve the limited battery power that such devices carry.

One possible architecture which may be used for such a power amplifier is called a Chireix architecture. Named after Henry Chireix who first proposed such an architecture in the 1930s, the Chireix architecture has fallen out of favor due to its seemingly inherent limitations. However, it has recently been revisited as it provides some advantages that other architectures do not have.

While the Chireix architecture provides some advantages, the process which the input signal undergoes also introduces some drawbacks. Specifically, distortions are introduced into the signal by the components in the Chireix based amplifier/modulator system. These distortions may also change over time and may therefore lead to a time-varying "drift" or change in the signal. Such distortions, time-varying or not, have led to problems that are not only inconvenient but expensive as well.

Based on the above, there is therefore a need for an amplifier system which provides the benefits of a Chireix based amplifier but which also compensates for or avoids the distortions which a Chireix based amplifier introduces. Such an amplifier system should adjust to differing conditions, preferably with little or no user intervention. It is therefore an object of the present invention to provide alternatives which mitigate if not overcome the disadvantages of the prior art.

U.S. Patent No. 6,246,286 discloses a system that adaptively compensates for non-linearities of a power amplifier. Digital information is supplied to a predistortion block that contains predistortion calculations and predistortion coefficients. The predistortion coefficients are stored in a predistortion lookup table and are periodically updated to compensate for time-varying non-linearities of the power amplifier. The output signal of the predistortion block is applied to a wave form generator which generates separate in-phase (I) and quadrature (Q) signals. The digital I and Q signals are converted to analog signals and are then combined in a linear modulator.

U.S. Patent No. 5,990,734 discloses a LINC amplifier of a radio frequency transmitter which provides substantially linear amplification from two nonlinear amplifiers by decomposing the original signal into two constant amplitude envelope, phase varying signals, which, when combined, constructively and destructively interfere to re-form the original signal. The LINC amplifier uses a digital control mechanism to control and adapt a digital compensation network that directly compensates for the imperfections of the analog RF environment, including the amplifiers. The mechanism corrects the component signals using information which can be applied to the amplifiers independent of the signal to be transmitted.

Patent document WO 01/08294 shows a further example of a feedback-based predistortion system where the input signal is decomposed into components that are processed separately.

SUMMARY OF THE INVENTION

The invention is defined by the independent claims. The dependent claims concern optional features of some embodiments of the invention.

BRIEF DESCRIPTION OF DRAWINGS

A better understanding of the invention will be obtained by considering the detailed description below, with reference to the following drawings in which:

Figure 1 is a block diagram of a Chireix architecture amplifier subsystem;

Figure 2 is a block diagram of an amplifier system using the subsystem of Fig 1 and a predistortion subsystem;

Figure 3 is a detailed block diagram of the internal components of the predistortion subsystem;

Figure 4 illustrates the amplifier system of Figure 2 and incorporates a feedback signal used by the predistortion subsystem of Figure 3;

Figure 5 is a block diagram of a delay line circuit which may be used in the system of Figure 4;

Figure 6 is a circuit which may be used to implement the magnitude adjustment explained below;

Figure 7 is a detailed block diagram of one embodiment of a Chireix amplifier subsystem;

Figure 8 is a block diagram of a signal processing system according to another embodiment of the invention; and

Figure 9 is a detailed block diagram of a system incorporating the feature shown in Figures 3, 4 and 8.

DETAILED DESCRIPTION OF THE INVENTION

For clarity, the following terms are to be used with the following definitions:
AM (amplitude modulation) refers to the AM of an RF (radio frequency) signal and is equal to the magnitude of the RF signal's complex base band equivalent PM (phase modulation) refers to the PM of an RF signal and is equal to the phase of the RF signal's complex base band equivalent.

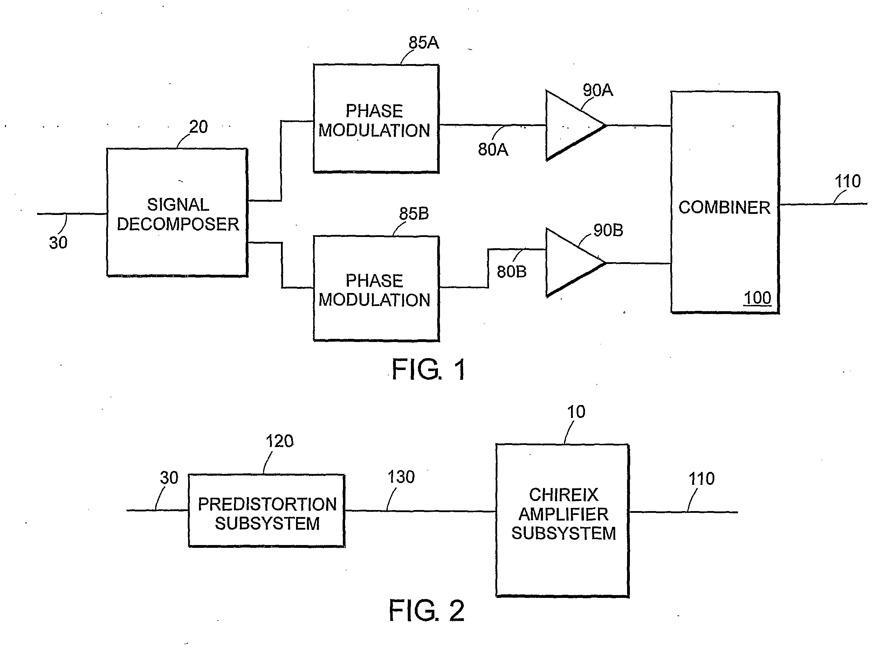

Referring to Figure 1, a block diagram of a Chireix architecture amplifier subsystem 10 is illustrated. A signal decomposer 20 receives an input complex baseband signal 30. Phase modulated signals 80A, 80B are produced after the decomposed output of the decomposer 20 are phase modulated by phase modulation circuitry 85A, 85B. These phase modulated signals 80A, 80B are received by power amplifiers 90A, 90B. The phase modulated signals are thus amplified by the power amplifiers 90A, 90B and are received by a signal combiner 100. The system output signal 110 (an RF signal corresponding to the input baseband signal 30) is output from the combiner 100 and is an amplified and modulated version of the input signal 30. Phase modulation of the phase modulated signals 80A, 80B is executed by the signal decomposer 20. The input signal 30 is separated into at least two components and these at least two components, after phase modulation, are the signals 80A, 80B.

As noted above, the Chireix architecture amplifier subsystem 10 has been known to introduce distortions in the system output signal 110. To compensate for such distortions, a predistortion subsystem 120 is provided. Referring to Figure 2, the predistortion subsystem 120 receives the input signal 30 and produces a predistorted signal 130. The predistorted signal 130 is received by the amplifier subsystem 10. The amplifier subsystem then produces the system output signal 110.

The distortions for which the predistortion subsystem is to compensate may come as a phase distortion, a magnitude distortion, or as a combination of both. It has been found that, without predistortion, the system output signal 110 has an amplitude modulation (AM) that is not equal to the expected and desired AM. Furthermore, the phase modulation (PM) of the system output signal 110, if predistortion is not present, deviates from the expected and desired PM. Experiments have found that the AM distortion or error (magnitude distortion) depends on the AM of the input signal. Also, it has been found that the PM distortion (or phase distortion) depends on the AM of the input signal.

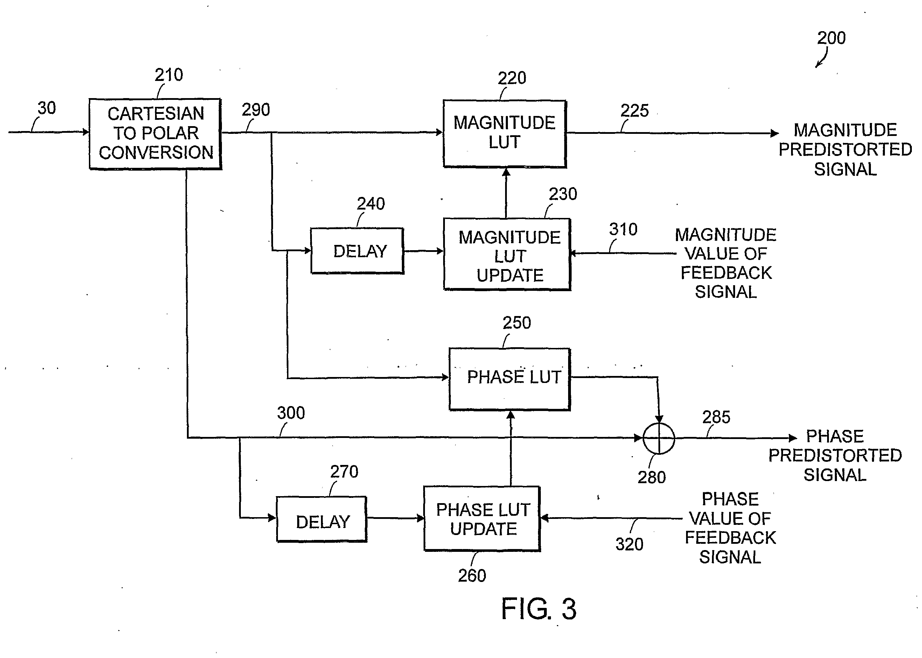

As noted above, one solution to the above issues is to predistort the input signal as detailed in Figure 2. Further details on this approach can be found in co-pending application entitled Predistortion Circuit For a Chireix Power Amplifier Transmit System and filed with the US Patent and Trademark Office. While the predistortion solution does work, it is not as robust and as fault tolerant as may be desirable. An adaptive predistortion subsystem 200, as illustrated in Figure 3, would compensate for changing conditions and for other distortions which the system output signal may have.

Referring to Figure 3, a block diagram of such an adaptive predistortion subsystem is illustrated. The adaptive predistortion subsystem 200 of Figure 3 may be used in place of the predistortion subsystem 120 of Figure 2.

While an analog implementation of the subsystem 200 is possible, it has been found that a digital implementation was simpler to achieve. As such, the following description assumes that the input signal 30 is a digital signal having a digital representation of the desired AM and PM of the desired output RF signal. Digital AM/AM predistortion modifies the magnitude of the complex digital input signal such that the RF output signal has the desired AM, despite the distortion. Digital AM/PM predistortion modifies the phase of the complex digital input signal such that the RF output has the desired PM, despite the distortion.

As can be seen in Figure 3, multiple components are involved in the adaptive predistortion subsystem 200: a Cartesian to polar conversion unit 210, a magnitude value lookup table (LUT) block 220, a magnitude update block 230, a magnitude delay block 240, a phase value lookup table (LUT) block 250, a phase value update block 260, a phase delay block 270, and an adder 280. The digital input signal 30 is converted by the conversion unit 210 from Cartesian coordinates to polar coordinates. The magnitude of the converted signal is then received and used by the lookup table blocks 220, 250 to determine the proper amount of predistortion to be applied. The phase lookup table 250 adds the phase distortion to the converted signal by way of the adder 280. The predistorted signal is then passed on to the amplifier subsystem 10.

It should be noted that the predistortion modification, defined as any deliberate distortion which has been introduced to the input signal to change at least the phase or magnitude of the input signal., can take many forms. Figure 3, provided merely for illustrative purposes, depicts two types of predistortion - phase predistortion and magnitude predistortion. These two types, separately or together, can make up the predistortion modification. In some applications, only a magnitude type predistortion modification may be required while in others only a phase type predistortion modification is required. In the embodiment explained here, the two types of predistortion, together comprise the predistortion modification.

To account for changing conditions and to acquire appropriate LUT entries, a feedback mechanism is employed to adjust or adapt the lookup table entries in lookup table blocks 220, 250. Delay blocks 240, 270 ensure that the feedback sample is mated with the proper value of the input signal waveform when processing and updating the lookup table entries in lookup table blocks 220, 250.

The conversion unit 210, while present, is not necessary but merely convenient and makes the predistortion easier to accomplish. As is well known, signal representations using Cartesian coordinates take the form of $z = x + j\,y$ where x and y are the real and imaginary components. Polar coordinates take the form of $z = Ae^{j\phi}$ where the magnitude of the signal is A and its phase is $\phi$. Since both the magnitude and the phase of the signal is to be modified by the predistortion subsystem, it is clearly more convenient to accomplish this if the signal were in polar coordinates. Again as is well known, $A = (x^2 + y^2)^{\frac{1}{2}}$ while $\phi = tan^{-1}\,(y/x)$. Once the signal has been converted into polar coordinates, adjusting the magnitude is as simple as replacing the digital representation of A by another number. Similarly, the phase can be adjusted by adding a phase correction to the phase of the signal.

After the digital input signal is received and converted by the conversion unit 210, the signal is now represented by two values - a magnitude value 290 and a phase value 300. Figure 3 shows the different signal paths followed by these values - one path for the magnitude value 290 and a second path for the phase value 300.

As noted above, the magnitude value 290 can be easily replaced by the predistorted magnitude value. This is done by way of magnitude lookup table block 220. The lookup table internal to the magnitude lookup table block 220 represents an input/output relationship with the input being the undistorted magnitude and the output being the predistorted signal magnitude. Thus, if the magnitude LUT block 220 has a table entry with an input value of 0.5 and an output value of 0.4, then if the undistorted magnitude value received by the magnitude LUT block 220 is 0.5, then this value is replaced with 0.4 as the output of the magnitude LUT block 220. Based on the LUT (lookup table) entries, the magnitude of the undistorted signal is therefore replaced with the desired predistorted magnitude.

Similar to the above, the phase value of the converted input signal is adjusted as well. As can be seen in Figure 3, the magnitude value 290 is also received by the phase lookup table block 250. The phase lookup table block 250, based on the magnitude value, determines the proper amount of phase adjustment and adds this phase adjustment to the phase value 300 by way of the adder 280. The phase lookup table block 250 also has a lookup table resident within the phase LUT block 250 that details the appropriate phase adjustments for given magnitude values.

While the above described magnitude LUT replaces a desired value for the received magnitude, other implementations are possible. Instead of a direct replacement value, the magnitude LUT may provide a corrective value to the received magnitude. This corrective value can, depending on the implementation, be an additive or a multiplicative corrective value.

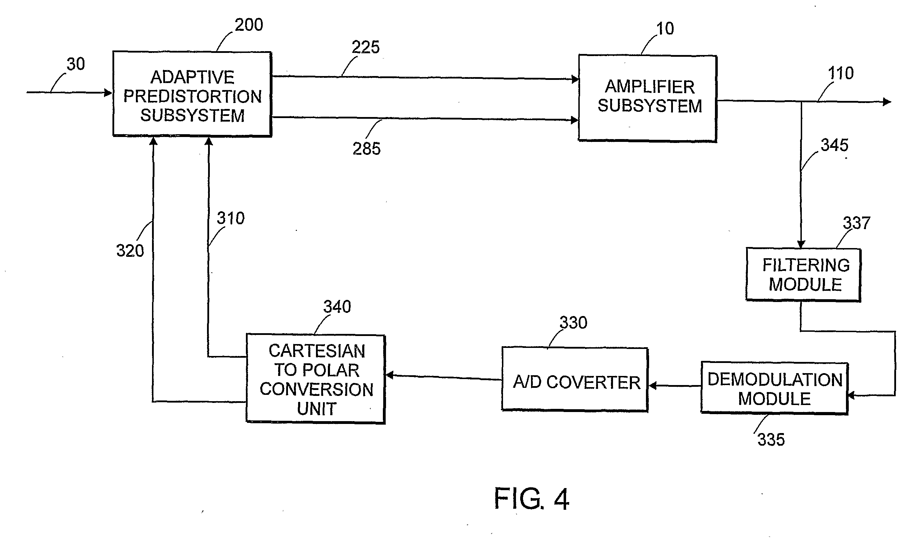

The adaptive predistortion subsystem 200 in Figure 3 is adaptive in that the values of the lookup table entries in the lookup table (LUT) blocks 220, 250 change over time to account for changing conditions or for acquiring appropriate LUT entries. This adaptability is implemented by way of a feedback signal tapped from the system output signal 110. Referring to Figures 3 and 4, two feedback signals, a magnitude feedback signal 310 and a phase feedback signal 320, are received by the magnitude value update block 230 and by the phase value update block 260 respectively. These two feedback signals result from processing of the system output signal 110 by the analog/digital (A/D) converter 330, the Cartesian to polar conversion unit 340, demodulation module 335, and filtering module 337. As can be seen in Figure 4, the system output signal (an analog signal) is tapped and this tapped signal 345 is received by the A/D converter 330 for conversion from an analog to a digital signal.

After conversion to a digital signal, the feedback signal is converted from Cartesian to polar coordinates by the conversion unit 340. The tapped signal 345 is thus represented by the two feedback signals - the magnitude feedback signal 310 and the phase feedback signal 320. As mentioned above, both these feedback signals are received by their respective update blocks 230, 260.

Once the two digital feedback signals are received, they are then compared with the delayed input signal coming from the delay blocks 240, 270. The updated values for the LUT entries are then calculated and entered into their respective lookup tables. It should be noted that the comparison may be done by subtracting the feedback signals from the delayed input signal.

To further elaborate on the above process, the update process is dependent on the difference between the tapped system output signal 345 and the input signal 30. This difference is, of course, taken after both signals are in polar coordinates. The magnitude and phase errors are defined as:

$$e_m(k) = |z(k)| - |x(k)|$$

$$e_\phi(k) = (\angle z(k) - \angle x(k))$$

where

$e_m(k)$ = magnitude error
$e_\phi(k)$ = phase error
z(k) = magnitude of feedback signal (signal 310)
x(k) = magnitude of input signal (signal 290)
$\angle z(k)$ = phase angle of feedback signal (signal 320)
$\angle x(k)$ = phase angle of input signal (signal 300)

For the magnitude LUT entries in the magnitude LUT block 220, two variables are defined and used in the process:

$$\delta_F = -\mu_F \cdot e_m(k)$$

where

$\delta_F$ =  update quantity dependent on the differences between the magnitudes of the input signal and the feedback signal
$\mu_F$ =  an update speed parameter $\mu$(user selectable), typically $\mu_F > 0$.

Since the magnitude LUT has LUT entries, each entry is given an entry address of n with $0 \leq \eta \leq N-1$, N being the maximum number of entries in the internal magnitude LUT in the magnitude LUT block 220.
An interpolation distance $s$ is defined as $s = \alpha M-n$ where $n = \lfloor \alpha M \rfloor$ (or the largest integer value less than or equal to $\alpha M$), M = |x (k)|, and $\alpha$ is a scaling value applied such that the magnitude range (e.g. $0 \leq M < 1$) is mapped to a table index range $0 \leq n \leq (N-1)$. The table entries are thus updated using the following formulae (n being one table address and n+1 being another table address)

$$F_n(k+1) = F_n(k) + (1-s)\cdot\delta_F \text{ iff } 0 \leq n \leq (N-1)$$

$$F_{n+1}(k+1) = F_{n+1}(k) + (s)\cdot\delta_F \text{ iff } 0 \leq n+1 \leq (N-1)$$

where

$F_n(k)$ = table entry n for time sample k
$F_n(k+1)$ = table entry n for time sample k + 1
$F_{n+1}(k)$ = table entry for n+1 for time sample k
$F_{n+1}(k+1)$ = table entry n+1 for time sample k+1

From the above equations, it should be clear that one, two or no entries in the internal magnitude LUT are updated depending on the value of $\alpha M$. Thus, for this implementation, depending on the value of $\alpha M$, one of $F_n$ and $F_{n+1}$ is updated, both are updated, or neither is updated. Other implementations, depending on the circumstances and needs of the particular application, may update other numbers of entries.
For the phase LUT entries, an analogous process is used in the phase update block 260. An update quantity is defined:

$$\delta_G = -\mu_G \cdot e_\phi(k)$$

where

$\delta_G =$ update quantity dependent on the differences between the phase angles of the input signal and of the system output signal

$\mu_G =$ an update speed parameter (user selectable) where $0 \leq \mu G < 1$

Using the parameters as defined above for the magnitude LUT, the phase LUT entries can be updated using the following formulas:

$$G_n(k+1) = G_n(k) + (1-s) \bullet \delta_G \text{ iff } 1 \leq n \leq (N-1)$$

$$G_{n+1}(k+1) = G_{n+1}(k+1) + (s) \bullet \delta_G \text{ iff } 1 \leq n \leq N$$

Again, much like the magnitude LUT entry update process, the update process for the phase entries will, depending on the value of $\alpha M$, update one, two, or none of the phase LUT entries.

It should be noted that LUT adaptation may involve updating more than two entries with some weighting applied. As an example, the weighting may depend upon the distance of the LUT entry from the update point. The discussion herein is based upon the use of two entries and the use of an interpretation distance.

As an example of the above processes, a phase entry update will be illustrated. For this example, the following values are assumed:

$$N = 6$$

$$M \leq 1$$

$$\alpha = 5$$

$$x(k) = 0.35 \exp(j \bullet 2 \bullet 7)$$

$$z(k) = 0.2 \exp(j \bullet 3 \bullet 1)$$

$$\mu_G = 0.1$$

Thus, M=0.35 and $\alpha M$ = 1.75. Thus, n=1 (since the lowest integer value less than or equal to 1.75 = 1) and n+1 = 2. From these values, $s$ = 1.75-1 = 0.75. Given that z(k) = 0.2 exp(j•2.3), the $e_\phi(k)$ = -0.4. Thus, $\delta_G$ = -(0.1)(-0.4) = +0.04. The required correction for $G_1$ is therefore

(1-$s$) $\delta_G$=(1-0.75)(+0.04) = 0.25•(+0.04) = 0.01. For $G_2$, the correction is $s$ •$\delta_G$ =(0.75)(0.04) = 0.03. The new values are therefore:

$$G_1(k+1) = G_1(k) + 0.01$$

$$G_2(k+1) = G_2(k) + 0.03$$

This update is illustrated by the values in the following table:

| Address (n) | LUT content before update | Correction | LUT content after update |
|---|---|---|---|
| 0 | -1 | 0 | -1 |

(continued)

| Address (n) | LUT content before update | Correction | LUT content after update |
|---|---|---|---|
| 1 | 2 | 0.01 | 2.01 |
| 2 | -0.5 | 0.03 | -0.47 |
| 3 | -0.5 | 0 | -0.5 |
| 4 | 0.5 | 0 | 0.5 |
| 5 | 2 | 0 | 2 |

It should be noted that the above process also takes into account the lookup of values that are not to be found in the internal lookup tables. Linear interpolation using $s = \alpha M - n$ is used for magnitude values that cannot be found in the lookup table entries. As an example, if the magnitude is given as 0.35 but the only table entries are 0.3 and 0.4, linear interpolation is used.

The following formula is used to find values not found in the lookup tables:
where

$$F(M) = (1 - s) \bullet F_n + s - F_{n+1}$$

where

$F_n$ = table value A
$F_{n+1}$ = table value B with the desired value being between table values A and B
$n = \lfloor \alpha M \rfloor$ (the largest integer value less than or equal to $\alpha M$)
$s = \alpha M - n$
$\alpha$ = scaling value as defined above.

From the above discussion, it should be fairly clear that two of the values underpinning most of the calculations are the values for $e_m(k)$ and $e_\phi(k)$, the magnitude and phase errors. While the equations above for these two values will provide acceptable answers, better results may be had by taking into account the phase, magnitude, and delay effects of the feedback signal (i.e. the tapped system output signal 345). However, to be able to do this, the input signal must be properly delayed so that samples from the interpolated input waveform, as obtained from the delayed input signal samples, are mated with the relevant system output signal sample. Such proper delaying should therefore take into account most, if not all, the time delay involved in the processing production, and feedback of the system output signal (round trip delay). This round trip delay is denoted as $\tau$ (seconds) and, before the LUT updating begins, the delay blocks 240, 270 acquires the delay and delays the input signal accordingly so as to time-align the input signal samples with the incoming feedback signal.

To implement this delay, a delay line is used with a depth of $K$, meaning $K$ samples of the input signals may be stored in the delay line. As should be clear, each of the K samples were sampled at different instances in time. The value of $K$ is predetermined and should be enough to allow for the maximum possible path delay between the input signal and the feedback signal. These delays are due to a combination of any of the following: digital pipelining, analog and digital filter group delays, analog propagation delays, and the system and implementation dependent delays.

Because of this delay, a time delayed version of the input signal, $x_\delta(k)$ is defined and this is ideally

$$x_\delta(k) = x(k-\delta)$$

where

$$\delta = \tau \bullet F_s$$

$F_s$ = signal sampling rate
$\tau$ = delay (normal trip delay between input and system output signal feedback)

To obtain a better result for $x_\delta(k)$, linear interpolation is used to allow for fractional values of $\delta$. Thus, the delay is divided into two parts K, the integer part of the sample (representing a discrete sample delay at the sample rate $F_s$), and v, a fractional sample of the delay.

Using this notation, the delayed portion of the input signal can be represented as:

$$x_\delta(k) = (1-v) \bullet x(k\text{-}\kappa) + v \bullet x(k\text{-}\kappa+1)$$

where

$$\delta = \tau \bullet F_s$$

$$\kappa = \lfloor \delta \rfloor$$

$$v = \delta\text{-}\kappa$$

As can be seen, for an integer $\delta$, $x_\delta(k) = x(k\text{-}\delta)$.

The above Cartesian equation can be applied to polar representations by having separate delay lines for magnitude ($|x_\delta(k)|$) and phase ($\angle x_\delta(k)$) using the sequences $|x(k)|$ and $\angle x(k)$. These are given by:

$$\angle x_\delta(k) = (1-v) \bullet \angle x(k\text{-}\kappa) + v \angle x(k\text{-}\kappa+1)$$

$$\left| x_\delta(k) \right| = (1-v) \bullet \left| x(k\text{-}\kappa) \right| + v \bullet \left| x(k\text{-}\kappa+1) \right|$$

It should be fairly clear that $x_\delta(k)$ is calculated from the samples $x(k)$, $x(k\text{-}1)$, $x(k\text{-}2)$, ....$x(k\text{-}\kappa)$, samples of the input signal taken at time k, k-1, k-2,... k-$\kappa$.

The above equations for $\angle x_\delta(k)$ has a peculiarity that is due to the way angle values work. Since $\angle x(k\text{-}\kappa)$ and $\angle x(k\text{-}\kappa+1)$ are represented by modulo $2\pi$ radians (360 degrees) and since $-\pi \le \angle x(k) \le \pi$, then errors could easily occur.

Thus, if $-\pi \le \angle x(k) \le \pi$, and if $|\angle x(k\text{-}\kappa+1) - \angle x(k\text{-}\kappa)| \ge \pi$, then

$$\angle x_\delta(k) = (1-v) \cdot \angle x(k\text{-}\kappa) + v \cdot (\angle x(k\text{-}\kappa+1) + 2\pi) \text{ if } \angle x(k\text{-}\kappa+1) \le \angle x(k\text{-}\kappa)$$

$$\angle x_\delta(k) = (1-v) \cdot \angle x(k\text{-}\kappa) + v \cdot (\angle x(k\text{-}\kappa+1) - 2\pi) \text{ if } \angle x(k\text{-}\kappa+1) > \angle x(k\text{-}\kappa)$$

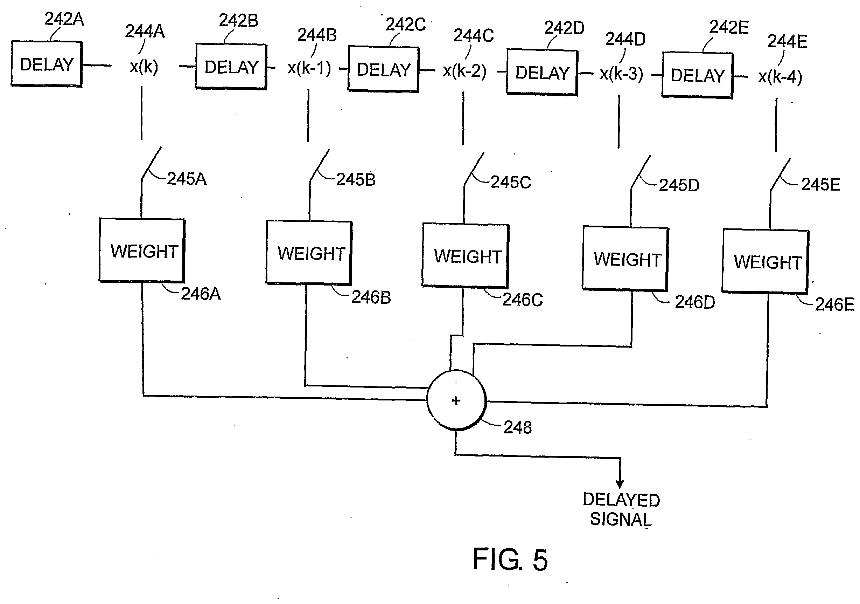

The above described delay can be implemented by cascaded delay elements and associated sample storage. Figure 5 illustrates such a delay subsystem which can be used as delay blocks 240, 270. As can be seen, delay elements 242A, 242B, 242C, 242D, 242E are cascaded and provide delays and storage for input signal samples 244A, 244B, 244C, 244D, 244E. Switches 245A, 245B, 245C, 245D, 245E allow any one of the signal samples 244A-244E to be switched so that it can be used. These samples 244A-244E can be weighted accordingly by programmable weighting blocks 246A, 246 B, 246C, 246D, 246E. The weighted samples are then summed up by adder 248 to produce the delayed signal 249 to be used by the system. The switches 245A...245E and the values in the weighting blocks 246A...246E may be user/system controllable so that any combination of weighted samples may be produced.

As an example, if $\tau F_s$, = 2.4 samples is required, then a value of 0.6 is used by the weighting block 246C and a value of 0.4 is used by the weighting block 245D. Then, by closing switches 245C and 245D then the sample x(k-2.4) is obtained.

The phase correction required for the feedback portion of the system output signal is also dependent on the delayed signal $x_\delta(k)$. The complex phase difference between the delayed signal $x_\delta(k)$ and the system output signal z(k), represented by $\gamma$, is due in part to the round trip delay and to other factors. The phase correction and delay can be found by executing the following process:

    1. Reset the running-maximum register: set $P_{max} = 0$

2. Reset the phase correction: set. $\gamma = 0$

3. Preset the variable interpolating delay line (discussed above as a delay subsystem) :set $\delta = \delta_0$ (i.e. $\kappa = \kappa_o$ and $v = v_o$)

4. Perform a coarse search: select only interpolating delay line integer sample-delay increments of $\delta$ (maintain $v = v_o$, increment $\kappa$ only): set the coarse and fine delay increments to $\Delta\kappa = 1$ and $\Delta v = 0$.

5. Start with the first correlation window $n = 0$. Time instance $k = 0$ signifies the commencement of the search.

6. "Integrate": calculate the inner product

$$P_\delta = A_{MAC} \cdot \sum_{k=n \cdot W}^{n \cdot W + W - 1} \exp\left(j \cdot \left(\angle x_\delta(k) - \angle z(k)\right)\right)$$

This is a complex multiply-and-accumulate (MAC) covering a time window of $W$ current samples. Note that the above notation strictly implies that the correlation windows $n = 0,1,2,...$ are adjoined, yet this is not an operational requirement. A spacing between windows translates to a lengthening of the search.

7. "Dump": compare the complex magnitude $|P_\delta|$ with the value $P_{max}$, and if $|P_\delta| > P_{max}$, $|P_\delta| > P_{max}$ then

(a) update the maximum: set $P_{max} = |P_\delta|$

(b) update the delay: retrieve the corresponding value of $\delta$ and store it as $\delta_{max}$ and

(c) update the angle: if fine searching store the angle $\gamma = \angle P_\delta$

8. Proceed to the next window: set n=n+1, and increment $\delta$ by $\Delta k + \Delta v$

9. Repeat from Step 4, until the full integer (coarse) delay range k =$k_0$... $K_v$ of the interpolating delay line is exhausted. ($K_v$ is the maximum variable delay, $\kappa_0$ is the starting coarse delay value for the search)

10. Store $\delta_{max}$ as $\delta_1$.

11. Read the programmed fine search step size $\Delta v$.

12. Repeat Steps 1 and 4 to 8 for the fine search: employ fractional-sample increments of $\Delta v$, covering the delays $\delta_1 - 1 \leq \delta \leq \delta_1 + 1$, ensuring not to exceed $0 \leq \delta \leq K_v$

13. Store $\delta_{max}$ as $\delta_2$.

14. Set and freeze the interpolating delay line delay to $\delta_2$.

15. Apply the phase correction $\gamma$

Once the full course range is exhausted, the stored $\delta$ value $\delta_{max}$ is used as a starting point for a fine search. With $\Delta\kappa = 0$, the $\Delta v$ is incremented fractionally so as to search the delays $\delta_1 - 1 \leq \delta \leq \delta + 1$. Once found (using an analogous loop to that used for the coarse search), the phase correction $\gamma$ is found along with the proper delay value. It should be clear that $\gamma = \angle P_\delta$.

Updating of the phase LUT is only to be accomplished after the phase synchronization of the feedback signal. Freezing the phase LUT update can be done by setting $\mu F = 0$ and $\mu G = 0$.

After the phase correction is done, the magnitude of the feedback signal z(k) has to be adjusted as well. This adjustment is required to compensate for any gain in the system output signal relative to the input signal. Magnitude adjustment is accomplished by directly multiplying the feedback signal z(k) by a factor $A_{sx}(k)$. This is found using the following formula:

$$A_{sx}(k+1) = A_{sx}(k) + \mu_A \cdot \left(\left|x_\delta(k)\right| - A_{sx}(k) \cdot |z(k)|\right)$$

For $K_A \leq k \leq k_{A+} W_A - 1$

where

$k_A$ = commencement time for the magnitude adjustments (preferably as early as possible)

$W_A$ = number of samples for which the adjustments are performed

$\mu_A$ = update step size and $0 <\_ \mu A <\_ 1$

$A_{sx}(k_A)$, $\mu_A$, and $W_A$ can be programmable.

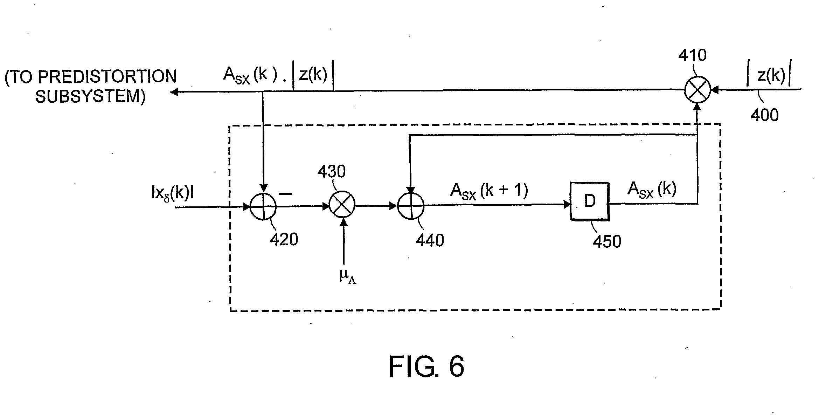

Referring to Figure 6, a circuit for implementing the magnitude adjustment is illustrated. As can be seen, the magnitude 400 of the portion of the system output signal is multiplied with the factor $A_{sx}(k)$ by way of multiplier 410. The result is to be used in calculating the desired predistortion modification. This result is also subtracted from the magnitude ($|x_\delta(k)|$) of the delayed signal by way of adder 420. The result of the subtraction is multiplied by the update step size $\mu_A$ by way of multiplier 430 and added to the factor $A_{sx}(k)$ by adder 440 to produce the next value in the sequence for the factor. The delay element 450 delays the resulting value until it is ready for use.

Once the delay, magnitude and phase adjustments have been made, new equations for the error signals can now be used:

$$E_m(k) = A_{sx} \cdot |z(k)| - |x_\delta(k)|$$

$$E_\phi(k) = (\gamma + \angle z(k) - \angle x_\delta(k))$$

These two error signals can therefore be used in place of the earlier ones and these take into account the effects of the delay, magnitude, and phase differences between the system output signal and the input signal.

While the above embodiment utilizes LUT entries that are adjusted based on the difference between the input signal and the system output signal, the system output signal alone may be used, if desired, in adjusting the LUT entries. This alternative would require the modulation of the system output signal and the regeneration of a signal similar to the input signal. Successful recovery is possible if the amount of distortion is restricted such that demodulation can occur without errors. This approach is not desirable if the input signal is readily available to be used in determining the parameters of the adjustments. Another alternative involves measuring the distortion by measuring the amount of out-of-band energy. Adjustments can then be made to minimize the amount of out-of-band energy and, consequently, minimize distortion.

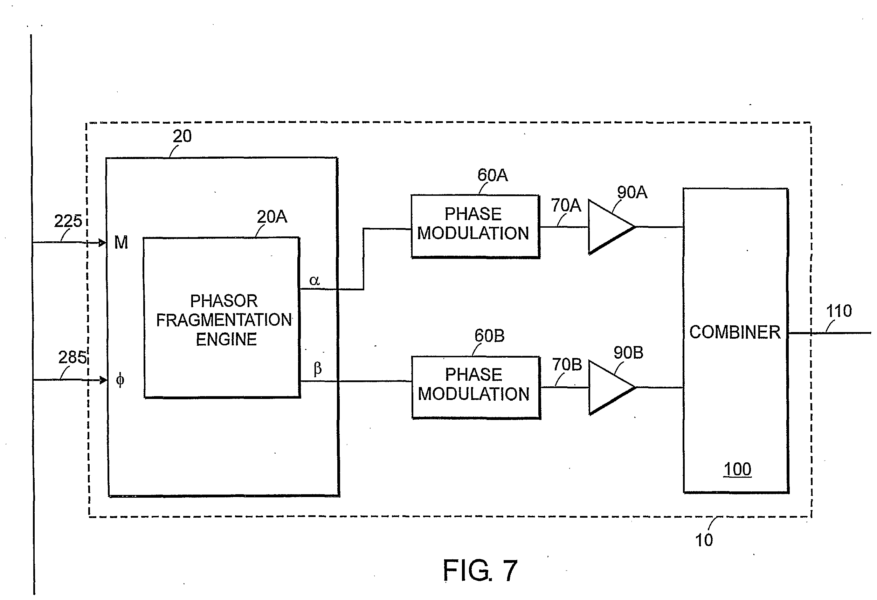

Regarding the amplifier subsystem 10, Figure 7 illustrates one embodiment of the subsystem 10. In Figure 7, the signal decomposer 20 of Figure 1 comprises a phasor fragmentation engine 20A along with phase modulation units 60A, 60B. The fragmentation engine 20A receives the magnitude (M) and phase ($\phi$) representing the predistorted signal. The phasor fragmentation engine 20A deconstructs a predetermined modulation waveform (the predistorted signal) into signal components which are of equal and constant magnitude. Further information regarding the phasor fragmentation engines may be found in the applicant's co-pending application US application No. 10/205,743 entitled COMPUTATIONAL CIRCUITS AND METHODS FOR PROCESSING MODULATED SIGNALS HAVING NON-CONSTANT ENVELOPES. In Figure 7, these signal components are denoted by angles $\alpha$ and $\beta$. These components are each received by RF modulation and filtering blocks 60A, 60B which process the components to produce RF modulated and filtered versions of the components. The signal component 70A is an RF signal with phase $\alpha$ while signal component 70B is an RF signal with phase $\beta$. These components 70A, 70B are then amplified by amplifiers 90A, 90B. The amplified components are then recombined using combiner 100. It should be noted that the phase modulation, also known as carrier modulation, may also introduce some undesired amplitude modulation. Signal decomposition methods other than the phasor fragmentation referred to above may also be used by the signal decomposer 20.

Regarding the Chireix architecture amplifier subsystem 10, it has been found that, for higher amplification efficiencies, switch mode amplifiers are preferred for the amplifiers 90A, 90B. Such switch mode amplifiers, specifically Class D and Class F power amplifiers, provide low output impedances that allow higher amplification efficiencies. A co-pending application filed on October 16, 2002 and having US Serial No. 10/272,725 entitled CHIREIX ARCHITECTURE USING LOW IMPEDANCE AMPLIFIERS provides further information on the desirable components. Such types of amplifiers are not required for the invention to function but they have been found to provide performance at a desirable level.

It should further be noted that while those are only two parallel amplifiers 90A, 90B in Figure 1 and Figure 7, multiple parallel amplifiers may be used as long as the decomposer 20 decomposes the predistorted signal 130 into enough components so that each component is separately amplified and phase modulated in parallel with the other components.

It should also be noted that the predistortion subsystem 10 explained above does not linearize a power amplifier as is well-known in the field. Instead, the predistortion subsystem linearizes a whole power amplifier system - the output of the whole amplifier system is linearized and not simply the output of a single amplifier. Also, unlike the linearizing systems for power amplifiers that are currently known, the amplifier system discussed in this document compensates for distortions that mostly occur at mid signal amplitudes. Current single amplifier linearization systems linearize distortions that occur at large signal amplitudes.

It should further be noted that the invention may be applied to any signal processing system which decomposes a signal into components and recombines them. It has been found that signal combiners (block 100 in Figure 1) invariably cause distortions. These combiners use addition to recombine the components and improper signal addition, such as when recombining sinusoidal components, has been found to be one cause of the distortions in the system output signal. In the above embodiment, the phasor fragmentation engine decomposes the incoming signal into vectors and the improper addition of these vectors by the combiner 100 lead to distortions in the output signal.

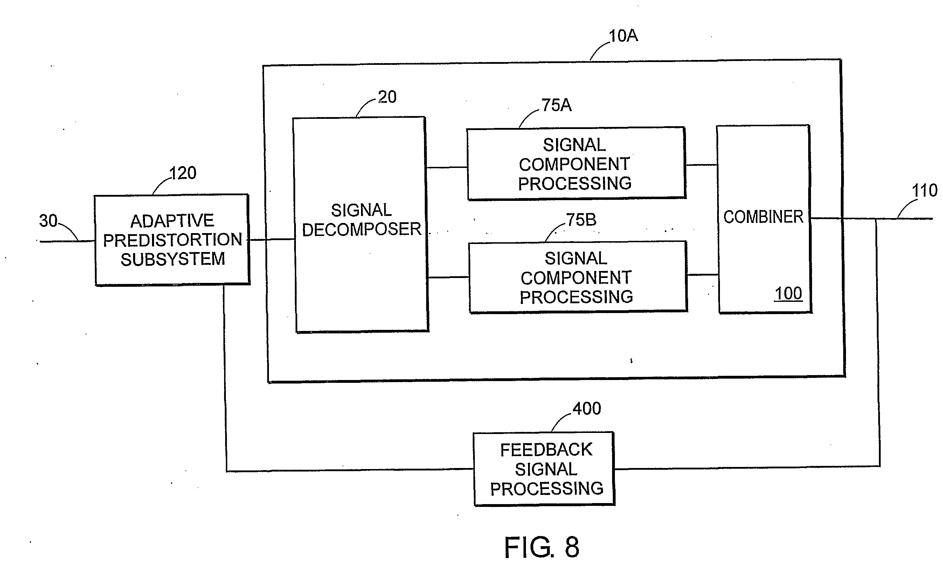

While the above embodiment amplifies the input signal, albeit separately for each component, this need not be the only signal processing accomplished after the input signal is decomposed. Referring to Figure 8, such a generalized system (which may be part of a larger signal transmission system) is illustrated. The predistortion subsystem 120 predistorts an incoming signal 30 and compensates for distortions introduced in the system output signal 110 by the improper or imperfect recombining of the input signals components. These components are produced by the signal decomposer 20 and are separately processed by signal component processor blocks 75A, 75B. The processing executed by the blocks 75A, 75B may take the form of amplification (as in the embodiment above), phase modulation, a combination of the two, or any other signal processing which may be desired. As an example, each of the signal components illustrated in Figure 7 may be separately phase modulated in addition to being amplified by amplifiers 90A-90B. The phase modulation may be accomplished separately or be incorporated in the signal decomposer or, as contemplated for the implementation illustrated in Figure 7, incorporated into the modulation and filtering blocks 60A, 60B.

As can be seen in Figure 8, the signal processing subsystem 10A receives the predistorted signal from the predistortion subsystem 120. After being received, the predistorted signal is decomposed by the signal decomposer 20 into components. These components are then separately processed by the signal component processor blocks 75A, 75B and are then recombined by the recombiner 100.

A feedback signal processing block 400 receives a portion of the system output signal 110 and processes this portion so it may be used by the adaptive predistortion subsystem 120. As an example, the feedback signal processing block 400 may contain the A/D converter 330 and the conversion unit 340 illustrated in Figure 4. The magnitude adjustment and phase adjustment detailed above can also be implemented in this block 400.

One advantage using the above invention is that it allows less stringent tolerances to be used for the system components. Previously, components had to be substantially matched so that signal processing could produce acceptable results. By using the above invention, less than substantially matched components may be used together. Errors due to a mismatch may be measured and compensated for by the predistortion subsystem.

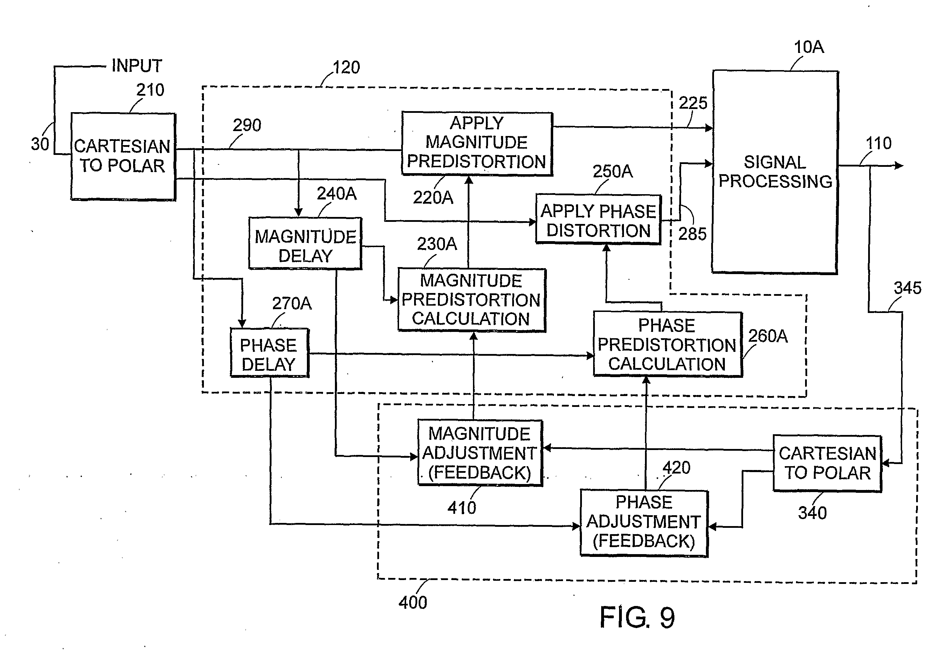

Referring to Figure 9, a detailed block diagram of a system incorporating the features illustrated in Figure 3, 4 and 8 is presented. As can be seen, the adaptive predistortion block 120 in Figure 8 is comprised of the separate magnitude delay 240 and phase delay 270 along with a magnitude predistortion calculation block 260A. The inputs of these calculation blocks 230A, 260A are the delayed input signals from the delay blocks 240, 270 and the adjusted feedback signals from the magnitude adjustment blocks 410 and the phase adjustment block 420. After the magnitude and phase predistortion modification are calculated, then the magnitude LUT block 220A and the phase LUT block 250A apply the predistortions. It should be noted that the magnitude LUT block 220A includes the magnitude LUT 220 and the magnitude LUT update block 230 shown in Figure 3. Similarly, the phase LUT block 250A incorporates the phase LUT 250 and the phase LUT update block 260 illustrated in Figure 3.

As can also be seen, the feedback signal processing block 400 illustrated in Figure 8 is comprised of the Cartesian to polar coordinate conversion block 340 which feeds the magnitude adjustment block 410 and the phase adjustment block 420.

A person understanding this invention may now conceive of alternative structures and embodiments or variations of the above. The scope of the invention is defined in the claims that follow.

## Claims

1.  A system for processing an input signal (30), the system comprising:

    a predistortion subsystem (120, 200) for receiving said input signal (30) and for producing a predistorted signal (130) by applying a deliberate predistortion to said input signal (30); and
    a signal processing subsystem (10, 10A) for receiving and processing said predistorted signal (130) and producing a system output signal (110),
    a feedback signal processing subsystem (400) for receiving and processing a feedback signal (345) derived from said system output signal (110); and
    a delay subsystem (240, 270, 270A) for providing a delay to a replica of said input signal (30) to produce a delayed signal, said delayed signal being used by said predistortion subsystem (120,200) and said feedback processing subsystem (400), wherein
    said predistortion subsystem (120, 200) is configured to distort said input signal (30) to compensate for distortions in said system output signal (110);
    said signal processing subsystem (10, 10A) is configured to decompose said predistorted signal (130) into separate components (70A, 70B, 80A, 80B), each of said separate components (70A, 70B, 80A, 80B) being processed separately; and
    said signal processing subsystem (10, 10A) is configured to combine said components (70A, 70B, 80A, 80B) after processing to produce said system output signal (110),
    said predistortion subsystem (120, 200) is configured to use an output of the feedback processing subsystem (400) and the deliberate predistortion applied to the input signal (30) is configured to be adjusted based on characteristics of the system output signal (110) and the input signal (30);

**characterised in that** said feedback signal processing subsystem (400) is configured to adjust a phase of a diverted replica of said system output signal (110) based on said input signal (30), wherein said phase is configured to be adjusted by applying a phase correction to said diverted replica, said feedback signal processing subsystem (400) being configured to initialize said phase correction by:

i) initiating a coarse delay search;
ii) selecting a time window of W samples of said feedback signal (345) and said input signal (30) with predetermined sample delay increments of $\delta$ between samples;
iii) calculating an inner product $P_\delta$ by performing a complex multiply and accumulate process for the W samples in the time window;
iv) storing a maximum $|P_\delta|$ found;
v) repeating steps c) and d) for subsequent time windows and incrementing $\delta$ by a predetermined amount for each time window; and
vi) repeating steps ii) - v) for a fine delay search using fractional sample increments to cover a predetermined delay range, said delay range being centered on a maximum delay increment $\delta_{max}$ found during said coarse delay search.

2. A system according to claim 1 wherein said signal processing subsystem (10, 10A) comprises:

a signal decomposer (20) for decomposing said predistorted signal (130) into at least two components (70A, 70B, 80A, 80B);
at least two signal component processor blocks (75A, 75B), each signal component processor block (75A, 75B) configured to receive an output of said signal decomposer (20) and each signal component processor block (75A, 75B) configured to separately process said output received from said signal decomposer (20); and
a combiner (100) receiving a processed output from each of said at least two signal component processor blocks (75A, 75B), said combiner (100) configured to produce said system output signal (110) from said processed outputs of said at least two signal component processor blocks (75A, 75B).

3. A system according to claim 2 wherein at least one of said at least two signal component processor blocks (75A, 75B) includes an amplifier (90A, 90B).

4. A system according to claim 3 wherein said amplifier (90A, 90B) is a non-linear amplifier.

5. A system according to claim 1 wherein said system is part of a signal transmission system.

6. A system according to claim 1 wherein at least some of said distortions are due to said combiner (100).

7. A system according to claim 3 wherein said amplifier (90A, 90B) is a switch mode amplifier.

8. A system according to claim 3 wherein said amplifier (90A, 90B) has a low output impedance.

9. A system according to claim 1 wherein said deliberate predistortion includes magnitude distortions which adjust a magnitude of said input signal (30).

10. A system according to claim 1 wherein said deliberate predistortion includes phase distortions which adjust a phase of said input signal (30).

11. A system according to claim 1 wherein said deliberate predistortion is based on at least one entry in a lookup table.

12. A system according to claim 11 wherein said deliberate predistortion is based on an interpolation of entries in said table.

13. The system of claim 1, wherein the deliberate predistortion applied to the input signal (30) is adjusted based on characteristics of the system output signal (110) and the input signal (30).

14. The system of claim 13, wherein the predistortion subsystem (120, 200) is an adaptive predistortion subsystem (120, 200).

15. A system according to claim 13 wherein said predistortion subsystem (120, 200) is configured to receive a replica of said system output signal (110).

16. A system according to claim 2 wherein said deliberate predistortion is dependent on differences between said input signal (30) and said replica of said system output signal (110).

17. A system according to claim 11 wherein entries in said lookup table are configured to be periodically updated based on characteristics of a replica of said system output signal (110).

18. A system according to claim 13 wherein said predistortion subsystem (120, 200) includes:

determining means for determining said deliberate predistortion;
adjustment means for applying said deliberate predistortion to said input signal (30);
update means for periodically updating said determining means based on characteristics of said system output signal (110).

19. A system according to claim 18 wherein said adjustment means is configured to receive parameters of said deliberate predistortion from said determining means.

20. A system according to claim 1 wherein said delay subsystem (240, 270, 270A) comprises:

a plurality of delay elements (242A - 242E); means for sampling said input signal (30);
means for storing samples of said input signal (30);
means for selecting selected samples of said input signal (30); and means for combining said selected samples of said input signal (30).

21. A system according to claim 1 wherein said delay subsystem (240, 270, 270A) comprises separate subsystems for separately delaying a magnitude and a phase of said input signal (30).

22. A method of processing an input signal (30) to produce a system output signal (110), the method comprising:

a) receiving said input signal (30);
b) applying a deliberate predistortion to said input signal (30) to result in a predistorted signal (130);
c) decomposing said predistorted signal (130) into at least two component signals (70A, 70B, 80A, 80B);
d) combining said at least two component signals (70A, 70B, 80A, 80B) to produce said system output signal (110);
e) adjusting said deliberate predistortion based on said characteristics of said system output signal (110);
f) concurrent with steps b) - e), executing the following steps:

f1) delaying a replica of said input signal (30);
f2) diverting a diverted replica of said system output signal (110) to a feedback path;
f3) processing said diverted replica to produce a corrected version of said diverted replica; and
f4) determining said deliberate predistortion using said corrected version and said replica of said input signal (30);

**characterised in that** said processing in step f3) comprises adjusting a phase of said diverted replica based on said input signal (30), wherein said phase is adjusted by applying a phase correction to said diverted replica, said phase correction being initialized by a method for initializing a phase correction to be applied to a feedback signal, said feedback signal to be used in determining a deliberate predistortion for a signal processing system, the method comprising:

i) initiating a coarse delay search;
ii) selecting a time window of W samples of said feedback signal and said input signal (30) with predetermined sample delay increments of $\delta$ between samples;
iii) calculating an inner product $P_\delta$ by performing a complex multiply and accumulate process for the W samples in the time window;

iv) storing a maximum $|P_\delta|$ found;

v) repeating steps iii) and iv) for subsequent time windows and incrementing $\delta$ by a predetermined amount for each time window; and

vi) repeating steps ii) - v) for a fine delay search using fractional sample increments to cover a predetermined delay range, said delay range being centered on a maximum delay increment $\delta_{max}$ found during said coarse delay search.

**23.** A method according to claim 22 wherein said system output signal (110) is an RF modulated version of said input signal (30).

**24.** A method according to claim 22 further including a processing step of separately processing each of said at least two component signals (70A, 70B, 80A, 80B) prior to step d).

**25.** A method according to claim 24 wherein said processing step includes amplifying at least one of said at least two component signals (70A, 70B, 80A, 80B).

**26.** A method according to claim 24 wherein said processing step includes phase modulating at least one of said at least two component signals (70A, 70B, 80A, 80B).

**27.** A method according to claim 22 wherein step a) further includes the step of accessing an entry in a lookup table, said deliberate predistortion being based on said entry.

**28.** A method according to claim 27 wherein said deliberate predistortion is based on an interpolation of entries in said table.

**29.** A method according to claim 22 further including the step of taking a difference between said input signal (30) and a replica of said system output signal (110) to determine said characteristics of said system output signal (110).

**30.** A method according to claim 22 further including the step of updating at least one entry in said lookup table (220, 250).

**31.** A method according to claim 22 wherein said deliberate predistortion is at least partially based on characteristics of said system output signal (110).

**32.** The method of claim 22 further comprising the step of taking a difference between said replica of said input signal (30) and said diverted replica of said system output signal(110) to determine said characteristics of said system output signal (110).

**33.** A method according to claim 22 wherein said processing in step f3) comprises adjusting a magnitude of said diverted replica based on said input signal (30).

**34.** A method according to claim 33 wherein said magnitude is adjusted by multiplying said diverted replica by $A_{sx}(k)$ where

$$A_{sx}(k+1) = A_{sx}(k) + \mu_A \cdot (|x_\delta(k)| - A_{sx}(k) \cdot |z(k)|)$$

for $k_A \leq k \leq k_A + W_A$ - 1 where

$k_A$ = commencement time for magnitude adjustments,
$W_A$ = number of samples for which adjustments are performed,
$\mu_A$ = update step size and $0 < \mu A < 1$,
$x_\delta(k)$ = is said input signal (30), and
$z(k)$ = is said feedback signal.

**35.** A method according to claim 32 wherein said deliberate predistortion is at least partially based on characteristics of said system output signal (110).

**Patentansprüche**

1. System zur Verarbeitung eines Eingangssignals (30), wobei das System Folgendes umfasst:

ein Vorverzerrungsuntersystem (120, 200) zum Empfangen des Eingangssignals (30) und zum Erzeugen eines vorverzerrten Signals (130), indem eine beabsichtigte Vorverzerrung am Eingangssignal (30) angewendet wird; und
ein Signalverarbeitung-Untersystem (10, 10A) zum Empfangen und Verarbeiten des vorverzerrten Signals (130) und Erzeugen eines Systemausgangssignals (110),
ein Rückkopplungssignalverarbeitung-Untersystem (400) zum Empfangen und Verarbeiten eines Rückkopplungssignals (345), das aus dem Systemausgangssignal (110) abgeleitet wird; und
ein Verzögerungsuntersystem (240, 270, 270A) zum Bereitstellen einer Verzögerung zu einer Kopie des Eingangssignals (30), um ein verzögertes Signal zu erzeugen, wobei das verzögerte Signal durch das Vorverzerrungsuntersystem (120, 200) und das Rückkopplungsverarbeitung-Untersystem (400) verwendet wird, wobei das Vorverzerrungsuntersystem (120, 200) dazu ausgelegt ist, das Eingangssignal (30) zu verzerren, um Verzerrungen im Systemausgangssignal (110) zu kompensieren;
das Signalverarbeitung-Untersystem (10, 10A) dazu ausgelegt ist, das vorverzerrte Signal (130) in separate Komponenten (70A, 70B, 80A, 80B) zu zerlegen, wobei jede der separaten Komponenten (70A, 70B, 80A, 80B) separat verarbeitet wird; und
das Signalverarbeitung-Untersystem (10, 10A) dazu ausgelegt ist, die Komponenten (70A, 70B, 80A, 80B) nach einer Verarbeitung zu kombinieren, um das Systemausgangssignal (110) zu erzeugen,
das Vorverzerrungsuntersystem (120, 200) dazu ausgelegt ist, eine Ausgabe des Rückkopplungsverarbeitung-Untersystems (400) zu verwenden, und die beabsichtigte Vorverzerrung, die am Eingangssignal (30) angewendet wird, ist dazu ausgelegt, basierend auf Charakteristiken des Systemausgangssignals (110) und des Eingangssignals (30) angepasst zu werden;
**dadurch gekennzeichnet, dass** das Rückkopplungssignalverarbeitung-Untersystem (400) dazu ausgelegt ist, eine Phase einer abgezweigten Kopie des Systemausgangssignals (110) basierend auf dem Eingangssignal (30) anzupassen, wobei die Phase dazu ausgelegt ist, durch Anwenden einer Phasenkorrektur an der abgezweigten Kopie angepasst zu werden, wobei das Rückkopplungssignalverarbeitung-Untersystem (400) dazu ausgelegt ist, die Phasenkorrektur durch Folgendes zu initiieren:

i) Initiieren einer groben Verzögerungssuche;
ii) Auswählen eines Zeitfensters von $W$ Abtastungen des Rückkopplungssignals (345) und des Eingangssignals (30) mit vorbestimmten Abtastungsverzögerungsinkrementen von $\delta$ zwischen Abtastungen;
iii) Berechnen eines inneren Produkts $P_\delta$, indem ein komplexer Multiplizieren-und-Akkumulieren-Prozess für die $W$ Abtastungen im Zeitfenster durchgeführt wird;
iv) Speichern eines gefundenen maximalen $|P_\delta|$;
v) Wiederholen der Schritte c) und d) für anschließende Zeitfenster und Inkrementieren von $\delta$ um einen vorbestimmten Betrag für jedes Zeitfenster; und
vi) Wiederholen der Schritte ii) - v) für eine feine Verzögerungssuche unter Verwendung von fraktionalen Abtastungsinkrementen, um einen vorbestimmten Verzögerungsbereich abzudecken, wobei der Verzögerungsbereich an einem maximalen Verzögerungsinkrement $\delta_{max}$ zentriert ist, das während der groben Verzögerungssuche gefunden wird.

2. System nach Anspruch 1, wobei das Signalverarbeitung-Untersystem (10, 10A) Folgendes umfasst:

einen Signalzerleger (20) zum Zerlegen des vorverzerrten Signals (130) in mindestens zwei Komponenten (70A, 70B, 80A, 80B);
mindestens zwei Signalkomponenten-Prozessorblöcke (75A, 75B), wobei jeder Signalkomponenten-Prozessorblock (75A, 75B) dazu ausgelegt ist, eine Ausgabe des Signalzerlegers (20) zu empfangen, und jeder Signalkomponenten-Prozessorblock (75A, 75B) dazu ausgelegt ist, die vom Signalzerleger (20) empfangene Ausgabe separat zu verarbeiten; und
einen Kombinierer (100), der eine verarbeitete Ausgabe von jedem der mindestens zwei Signalkomponenten-Prozessorblöcke (75A, 75B) empfängt, wobei der Kombinierer (100) dazu ausgelegt ist, das Systemausgangssignal (110) aus den verarbeiteten Ausgaben der mindestens zwei Signalkomponenten-Prozessorblöcke (75A, 75B) zu erzeugen.

3. System nach Anspruch 2, wobei mindestens einer der mindestens zwei Signalkomponenten-Prozessorblöcke (75A, 75B) einen Verstärker (90A, 90B) beinhaltet.

4. System nach Anspruch 3, wobei der Verstärker (90A, 90B) ein nichtlinearer Verstärker ist.

5. System nach Anspruch 1, wobei das System Teil eines Signalübertragungssystems ist.

6. System nach Anspruch 1, wobei zumindest manche der Verzerrungen aufgrund des Kombinierers (100) auftreten.

7. System nach Anspruch 3, wobei der Verstärker (90A, 90B) ein Schaltverstärker ist.

8. System nach Anspruch 3, wobei der Verstärker (90A, 90B) eine niedrige Ausgangsimpedanz aufweist.

9. System nach Anspruch 1, wobei die beabsichtigte Vorverzerrung Größenverzerrungen beinhaltet, die eine Größe des Eingangssignals (30) anpassen.

10. System nach Anspruch 1, wobei die beabsichtigte Vorverzerrung Phasenverzerrungen beinhaltet, die eine Phase des Eingangssignals (30) anpassen.

11. System nach Anspruch 1, wobei die beabsichtigte Vorverzerrung auf mindestens einem Eintrag in einer Nachschlagetabelle basiert.

12. System nach Anspruch 11, wobei die beabsichtigte Vorverzerrung auf einer Interpolation von Einträgen in der Tabelle basiert.

13. System nach Anspruch 1, wobei die beabsichtigte Vorverzerrung, die am Eingangssignal (30) angewendet wird, basierend auf Charakteristiken des Systemausgangssignals (110) und des Eingangssignals (30) angepasst wird.

14. System nach Anspruch 13, wobei das Vorverzerrungsuntersystem (120, 200) ein adaptives Vorverzerrungsuntersystem (120, 200) ist.

15. System nach Anspruch 13, wobei das Vorverzerrungsuntersystem (120, 200) dazu ausgelegt ist, eine Kopie des Systemausgangssignals (110) zu empfangen.

16. System nach Anspruch 2, wobei die beabsichtigte Vorverzerrung von Differenzen zwischen dem Eingangssignal (30) und der Kopie des Systemausgangssignals (110) abhängt.

17. System nach Anspruch 11, wobei Einträge in der Nachschlagetabelle dazu ausgelegt sind, basierend auf Charakteristiken einer Kopie des Systemausgangssignals (110) periodisch aktualisiert zu werden.

18. System nach Anspruch 13, wobei das Vorverzerrungsuntersystem (120, 200) Folgendes beinhaltet:

Bestimmungsmittel zum Bestimmen der beabsichtigten Vorverzerrung;
Anpassungsmittel zum Anwenden der beabsichtigten Vorverzerrung am Eingangssignal (30);
Aktualisierungsmittel zum periodischen Aktualisieren des Bestimmungsmittels basierend auf Charakteristiken des Systemausgangssignals (110).

19. System nach Anspruch 18, wobei das Anpassungsmittel dazu ausgelegt ist, Parameter der beabsichtigten Vorverzerrung vom Bestimmungsmittel zu empfangen.

20. System nach Anspruch 1, wobei das Verzögerungsuntersystem (240, 270, 270A) Folgendes umfasst:

mehrere Verzögerungselemente (242A - 242E); Mittel zum Abtasten des Eingangssignals (30);
Mittel zum Speichern von Abtastungen des Eingangssignals (30);
Mittel zum Auswählen von ausgewählten Abtastungen des Eingangssignals (30); und Mittel zum Kombinieren der ausgewählten Abtastungen des Eingangssignals (30).

21. System nach Anspruch 1, wobei das Verzögerungsuntersystem (240, 270, 270A) separate Untersysteme zum separaten Verzögern einer Größe und einer Phase des Eingangssignals (30) umfasst.

22. Verfahren zur Verarbeitung eines Eingangssignals (30), um ein Systemausgangssignal (110) zu erzeugen, wobei das Verfahren Folgendes umfasst:

a) Empfangen des Eingangssignals (30);
b) Anwenden einer beabsichtigten Vorverzerrung am Eingangssignal (30), was zu einem vorverzerrten Signal (130) führt;
c) Zerlegen des vorverzerrten Signals (130) in mindestens zwei Komponentensignale (70A, 70B, 80A, 80B);
d) Kombinieren der mindestens zwei Komponentensignale (70A, 70B, 80A, 80B), um das Systemausgangssignal (110) zu erzeugen;
e) Anpassen der beabsichtigten Vorverzerrung basierend auf den Charakteristiken des Systemausgangssignals (110);
f) gleichzeitig mit den Schritten b) - e), Ausführen der folgenden Schritte:

f1) Verzögern einer Kopie des Eingangssignals (30) ;
f2) Abzweigen einer abgezweigten Kopie des Systemausgangssignals (110) zu einem Rückkopplungspfad;
f3) Verarbeiten der abgezweigten Kopie, um eine korrigierte Version der abgezweigten Kopie zu erzeugen; und
f4) Bestimmen der beabsichtigten Vorverzerrung unter Verwendung der korrigierten Version und der Kopie des Eingangssignals (30);

**dadurch gekennzeichnet, dass** das Verarbeiten im Schritt f3) ein Anpassen einer Phase der abgezweigten Kopie basierend auf dem Eingangssignal (30) umfasst, wobei die Phase angepasst wird, indem eine Phasenkorrektur an der abgezweigten Kopie angewendet wird, wobei die Phasenkorrektur durch ein Verfahren zum Initialisieren einer Phasenkorrektur, die an einem Rückkopplungssignal angewendet werden soll, initialisiert wird, wobei das Rückkopplungssignal beim Bestimmen einer beabsichtigten Vorverzerrung für ein Signalverarbeitungssystem verwendet werden soll, wobei das Verfahren Folgendes umfasst:

i) Initiieren einer groben Verzögerungssuche;
ii) Auswählen eines Zeitfensters von $W$ Abtastungen des Rückkopplungssignals und des Eingangssignals (30) mit vorbestimmten Abtastungsverzögerungsinkrementen von $\delta$ zwischen Abtastungen;
iii) Berechnen eines inneren Produkts $P_\delta$, indem ein komplexer Multiplizieren-und-Akkumulieren-Prozess für die $W$ Abtastungen im Zeitfenster durchgeführt wird;
iv) Speichern eines gefundenen maximalen $|P_\delta|$;
v) Wiederholen der Schritte iii) und iv) für anschließende Zeitfenster und Inkrementieren von $\delta$ um einen vorbestimmten Betrag für jedes Zeitfenster; und
vi) Wiederholen der Schritte ii) - v) für eine feine Verzögerungssuche unter Verwendung von fraktionalen Abtastungsinkrementen, um einen vorbestimmten Verzögerungsbereich abzudecken, wobei der Verzögerungsbereich an einem maximalen Verzögerungsinkrement $\delta_{max}$ zentriert ist, das während der groben Verzögerungssuche gefunden wird.

23. Verfahren nach Anspruch 22, wobei das Systemausgangssignal (110) eine HF-modulierte Version des Eingangssignals (30) ist.

24. Verfahren nach Anspruch 22, ferner enthaltend einen Verarbeitungsschritt zum separaten Verarbeiten von jedem der mindestens zwei Komponentensignale (70A, 70B, 80A, 80B) vor dem Schritt d).

25. Verfahren nach Anspruch 24, wobei der Verarbeitungsschritt ein Verstärken von mindestens einem der mindestens zwei Komponentensignale (70A, 70B, 80A, 80B) enthält.

26. Verfahren nach Anspruch 24, wobei der Verarbeitungsschritt ein Phasenmodulieren von mindestens einem der mindestens zwei Komponentensignale (70A, 70B, 80A, 80B) enthält.

27. Verfahren nach Anspruch 22, wobei der Schritt a) ferner den Schritt des Zugreifens auf einen Eintrag in einer Nachschlagetabelle enthält, wobei die beabsichtigte Vorverzerrung auf dem Eintrag basiert.

28. Verfahren nach Anspruch 27, wobei die beabsichtigte Vorverzerrung auf einer Interpolation von Einträgen in der Tabelle basiert.

**29.** Verfahren nach Anspruch 22, das ferner den Schritt des Bildens einer Differenz zwischen dem Eingangssignal (30) und einer Kopie des Systemausgangssignals (110) enthält, um die Charakteristiken des Systemausgangssignals (110) zu bestimmen.

**30.** Verfahren nach Anspruch 22, das ferner den Schritt des Aktualisierens von mindestens einem Eintrag in der Nachschlagetabelle (220, 250) enthält.

**31.** Verfahren nach Anspruch 22, wobei die beabsichtigte Vorverzerrung zumindest teilweise auf Charakteristiken des Systemausgangssignals (110) basiert.

**32.** Verfahren nach Anspruch 22, das ferner den Schritt des Bildens einer Differenz zwischen der Kopie des Eingangssignals (30) und der abgezweigten Kopie des Systemausgangssignals (110) umfasst, um die Charakteristiken des Systemausgangssignals (110) zu bestimmen.

**33.** Verfahren nach Anspruch 22, wobei die Verarbeitung im Schritt f3) ein Anpassen einer Größe der abgezweigten Kopie basierend auf dem Eingangssignal (30) umfasst.

**34.** Verfahren nach Anspruch 33, wobei die Größe angepasst wird, indem die abgezweigte Kopie mit $A_{sx}(k)$ multipliziert wird, wobei

$$A_{SX}(k+1) = A_{SX}(k) + \mu_A \cdot (|x_\delta(k)| - A_{SX}(k) \cdot |z(k)|)$$

für $k_A \leq k \leq k_A + W_A - 1$
wobei

$k_A$ = Anfangszeit für Größenanpassungen,
$W_A$ = Anzahl von Abtastungen, für die Anpassungen durchgeführt werden,
$\mu_A$ = Aktualisierungsschrittgröße und $0 < \mu_A < 1$,
$x_\delta(k)$ = das Eingangssignal (30) ist, und
$z(k)$ = das Rückkopplungssignal ist.

**35.** Verfahren nach Anspruch 32, wobei die beabsichtigte Vorverzerrung zumindest teilweise auf Charakteristiken des Systemausgangssignals (110) basiert.

**Revendications**

**1.** Système pour traiter un signal d'entrée (30), le système comprenant :

un sous-système de prédistorsion (120, 200) pour recevoir ledit signal d'entrée (30) et pour produire un signal prédéformé (130) en appliquant une prédistorsion voulue audit signal d'entrée (30) ; et
un sous-système de traitement de signal (10, 10A) pour recevoir et traiter ledit signal prédéformé (130) et produire un signal de sortie système (110) ;
un sous-système de traitement de signal retour (400) pour recevoir et traiter un signal retour (345) dérivé dudit signal de sortie système (110) ; et
un sous-système de retard (240, 270, 270A) pour fournir un retard à une réplique dudit signal d'entrée (30) pour produire un signal retardé, ledit signal retardé est utilisé par ledit sous-système de prédistorsion (120, 200) et ledit sous-système de traitement retour (400) ; dans lequel
ledit sous-système de prédistorsion (120, 200) est conçu pour déformer ledit signal d'entrée (30) afin de compenser des distorsions dans ledit signal de sortie système (110) ;
ledit sous-système de traitement de signal (10, 10A) est conçu pour décomposer ledit signal prédéformé (130) en composantes distinctes (70A, 70B, 80A, 80B), chacune desdites composantes distinctes (70A, 70B, 80A, 80B) étant traitée séparément ; et
ledit sous-système de traitement de signal (10, 10A) est conçu pour combiner lesdites composantes (70A, 70B, 80A, 80B) après le traitement afin de produire ledit signal de sortie système (110) ;
ledit sous-système de prédistorsion (120, 200) est conçu pour utiliser une sortie du sous-système de traitement retour (400) et la prédistorsion voulue appliquée au signal d'entrée (30) est conçue pour être ajustée en fonction de caractéristiques du signal de sortie système (110) et du signal d'entrée (30) ;

**caractérisé en ce que** ledit sous-système de traitement de signal retour (400) est conçu pour ajuster une phase d'une réplique déviée dudit signal de sortie système (110) en fonction dudit signal d'entrée (30), dans lequel ladite phase est conçue pour être ajustée en appliquant une correction de phase à ladite réplique déviée, ledit sous-système de traitement de signal retour (400) étant conçu pour initialiser ladite correction de phase en :

i) lançant une recherche de retard grossière ;

ii) choisissant un créneau temporel de $W$ échantillons dudit signal retour (345) et dudit signal d'entrée (30) avec des incréments de retard d'échantillons prédéterminés $\delta$ entre les échantillons ;

iii) calculant un produit interne $P_\delta$ en effectuant un processus de multiplication et accumulation complexe pour les $W$ échantillons dans le créneau temporel ;

iv) stockant un maximum $|\mathbf{P}_\delta|$ trouvé ;

v) répétant les étapes c) et d) pour les créneaux temporels suivants et incrémentant $\delta$ selon une quantité prédéterminée pour chaque créneau temporel ; et

vi) répétant les étapes ii) à v) pour une recherche de retard affinée en utilisant des incréments d'échantillons fractionnels pour couvrir une plage de retard prédéterminée, ladite plage de retard étant centrée sur un incrément de retard maximal $\delta_{max}$ trouvé pendant ladite recherche de retard grossière.

2. Système selon la revendication 1, dans lequel ledit sous-système de traitement de signal (10, 10A) comprend :

un décomposeur de signal (20) pour décomposer ledit signal prédéformé (130) en au moins deux composantes (70A, 70B, 80A, 80B) ;

au moins deux blocs de processeur de composante de signal (75A, 75B), chaque bloc de processeur de composante de signal (75A, 75B) étant conçu pour recevoir une sortie dudit décomposeur de signal (20) et chaque bloc de processeur de composante de signal (75A, 75B) étant conçu pour traiter séparément ladite sortie reçue depuis ledit décomposeur de signal (20) ; et

un combineur (100) conçu pour recevoir une sortie traitée depuis chacun desdits au moins deux blocs de processeur de composante de signal (75A, 75B), ledit combineur (100) étant conçu pour produire ledit signal de sortie système (110) à partir des sorties traitées desdits au moins deux blocs de processeur de composante de signal (75A, 75B).

3. Système selon la revendication 2, dans lequel au moins un desdits au moins deux blocs de processeur de composante de signal (75A, 75B) comprend un amplificateur (90A, 90B).

4. Système selon la revendication 3, dans lequel ledit amplificateur (90A, 90B) est un amplificateur non linéaire.

5. Système selon la revendication 1, dans lequel ledit système fait partie d'un système de transmission de signal.

6. Système selon la revendication 1, dans lequel au moins certaines des distorsions sont dues audit combineur (100) .

7. Système selon la revendication 3, dans lequel ledit amplificateur (90A, 90B) est un amplificateur à mode commuté.

8. Système selon la revendication 3, dans lequel ledit amplificateur (90A, 90B) possède une faible impédance de sortie.

9. Système selon la revendication 1, dans lequel ladite prédistorsion voulue comprend des distorsions de magnitude qui ajustent une magnitude dudit signal d'entrée (30).

10. Système selon la revendication 1, dans lequel ladite prédistorsion voulue comprend des distorsions de phase qui ajustent une phase dudit signal d'entrée (30).

11. Système selon la revendication 1, dans lequel ladite prédistorsion voulue est basée sur au moins une entrée dans une table à consulter.

12. Système selon la revendication 11, dans lequel ladite prédistorsion voulue est basée sur une interpolation d'entrées dans ladite table.

13. Système selon la revendication 1, dans lequel la prédistorsion voulue appliquée au signal d'entrée (30) est ajustée en fonction de caractéristiques du signal de sortie système (110) et du signal d'entrée (30).

**14.** Système selon la revendication 13, dans lequel le sous-système de prédistorsion (120, 200) est un sous-système de prédistorsion adaptative (120, 200).

**15.** Système selon la revendication 13, dans lequel ledit sous-système de prédistorsion (120, 200) est conçu pour recevoir une réplique dudit signal de sortie système (110) .

**16.** Système selon la revendication 2, dans lequel ladite prédistorsion voulue dépend de différences entre ledit signal d'entrée (30) et ladite réplique dudit signal de sortie système (110).

**17.** Système selon la revendication 11, dans lequel les entrées dans ladite table à consulter sont conçues pour être périodiquement mises à jour en fonction de caractéristiques d'une réplique dudit signal de sortie système (110).

**18.** Système selon la revendication 13, dans lequel ledit sous-système de prédistorsion (120, 200) comprend :

un moyen de détermination pour déterminer ladite prédistorsion voulue ;
un moyen d'ajustement pour appliquer ladite prédistorsion voulue audit signal d'entrée (30) ;
un moyen de mise à jour pour mettre à jour périodiquement ledit moyen de détermination en fonction de caractéristiques dudit signal de sortie système (110).

**19.** Système selon la revendication 18, dans lequel ledit moyen d'ajustement est conçu pour recevoir des paramètres de ladite prédistorsion voulue depuis ledit moyen de détermination.

**20.** Système selon la revendication 1, dans lequel ledit sous-système de retard (240, 270, 270A) comprend :

une pluralité d'éléments de retard (242A-242E) ;
un moyen pour échantillonner ledit signal d'entrée (30) ;
un moyen pour stocker les échantillons dudit signal d'entrée (30) ;
un moyen pour choisir des échantillons choisis dudit signal d'entrée (30) ; et
un moyen pour combiner les échantillons choisis dudit signal d'entrée (30).

**21.** Système selon la revendication 1, dans lequel ledit sous-système de retard (240, 270, 270A) comprend des sous-systèmes distincts pour retarder séparément une magnitude et une phase dudit signal d'entrée (30).

**22.** Procédé de traitement d'un signal d'entrée (30) pour produire un signal de sortie système (110), le procédé consistant à :

a) recevoir ledit signal d'entrée (30) ;
b) appliquer une prédistorsion voulue audit signal d'entrée (30) pour obtenir un signal prédéformé (130) ;
c) décompser ledit signal prédéformé (130) en au moins deux signaux de composante (70A, 70B, 80A, 80B) ;
d) combiner lesdits au moins deux signaux de composante (70A, 70B, 80A, 80B) pour produire ledit signal de sortie système (110) ;
e) ajuster ladite prédistorsion voulue en fonction desdites caracéristiques dudit signal de sortie système (110) ;
f) en concurrence avec les étapes b) à e), exécuter les étapes suivantes :

f1) retarder une réplique dudit signal d'entrée (30) ;
f2) dévier une réplique déviée dudit signal de sortie système (110) vers un trajet de retour ;
f3) traiter ladite réplique déviée afin de produire une version corrigée de ladite réplique déviée ; et
f4) déterminer ladite prédistorsion voulue en utilisant ladite version corrigée et ladite réplique dudit signal d'entrée (30) ;

**caractérisé en ce que** ledit traitement lors de l'étape f3) consiste à ajuster une phase de ladite réplique déviée en fonction dudit signal d'entrée (30), dans lequel ladite phase est ajustée an appliquant une correction de phase à ladite réplique déviée, ladite correction de phase étant lancée par un procédé pour lancer une correction de phase à appliquer à un signal retour, ledit signal retour étant utilisé pour déterminer une prédistorsion voulue pour un système de traitement de signal, le procédé consistant à :

i) lancer une recherche de retard grossière ;
ii) choisir un créneau temporel de $W$ échantillons dudit signal retour et dudit signal d'entrée (30) avec des incréments de retard d'échantillons prédéterminés δ entre les échantillons ;

iii) calculer un produit interne $P_\delta$ en effectuant un processus de multiplication et accumulation complexe pour les *W* échantillons dans le créneau temporel ;

iv) stocker un maximum $|\mathbf{P}_\delta|$ trouvé ;

v) répéter les étapes iii) et iv) pour les créneaux temporels suivants et incrémenter δ selon une quantité prédéterminée pour chaque créneau temporel ; et

vi) répéter les étapes ii) à v) pour une recherche de retard fine en utilisant des incréments d'échantillons fractionnels pour couvrir une plage de retard prédéterminée, laquelle plage de retard étant centrée sur un incrément de retard maximal $\delta_{max}$ trouvé pendant ladite recherche de retard grossière.

**23.** Procédé selon la revendication 22, dans lequel ledit signal de sortie système (110) est une version modulée RF dudit signal d'entrée (30).

**24.** Procédé selon la revendication 22, comprenant en outre une étape de traitement consistant à traiter séparément chacun desdits au moins deux signaux de composante (70A, 70B, 80A, 80B) avant l'étape d).

**25.** Procédé selon la revendication 24, dans lequel ladite étape de traitement consiste à amplifier au moins un desdits au moins deux signaux de composante (70A, 70B, 80A, 80B).

**26.** Procédé selon la revendication 24, dans lequel ladite étape de traitement consiste à moduler en phase au moins un desdits au moins deux signaux de composante (70A, 70B, 80A, 80B).

**27.** Procédé selon la revendication 22, dans lequel l'étape a) comprend en outre l'étape consistant à accéder à une entrée dans une table à consulter, ladite prédistorsion voulue étant basée sur ladite entrée.

**28.** Procédé selon la revendication 27, dans lequel ladite prédistorsion voulue est basée sur une interpolation des entrées dans ladite table.

**29.** Procédé selon la revendication 22, comprenant en outre l'étape consistant à prendre une différence entre ledit signal d'entrée (30) et une réplique dudit signal de sortie système (110) afin de déterminer lesdites caractéristiques dudit signal de sortie système (110).

**30.** Procédé selon la revendication 22, comprenant en outre l'étape consistant à mettre à jour au moins une entrée dans ladite table à consulter (220, 250).

**31.** Procédé selon la revendication 22, dans lequel ladite prédistorsion voulue est au moins en partie basée sur des caractéristiques dudit signal de sortie système (110).

**32.** Procédé selon la revendication 22, comprenant en outre l'étape consistant à prendre une différence entre ladite réplique dudit signal d'entrée (30) et ladite réplique déviée dudit signal de sortie système (110) afin de déterminer lesdites caractéristiques dudit signal de sortie système (110).

**33.** Procédé selon la revendication 22, dans lequel ledit traitement lors de l'étape f3) consiste à ajuster une magnitude de ladite réplique déviée en fonction dudit signal d'entrée (30).

**34.** Procédé selon la revendication 33, dans lequel ladite magnitude est ajustée en multipliant ladite réplique déviée par $A_{sx}(k)$, où

$$A_{sx}(k+1) = A_{sx}(k) + \mu_A \bullet (|x_\delta(k)| - A_{sx}(k) \bullet (|z(k)|)$$

pour $k_A \leq k \leq k_A + W_A - 1$
où

$k_A$ = temps de début des ajustements de magnitude ;
$W_A$ = nombre d'échantillons pour lesquels des ajustements sont effectués ;
$\mu_A$ = taille de l'étape de mise à jour et $0 < \mu_A < 1$;
$x_\delta(k)$ = est ledit signal d'entrée (30) ; et

$z(k)$ = est ledit signal retour.

**35.** Procédé selon la revendication 32, dans lequel ladite prédistorsion voulue est au moins en partie basée sur des caractéristiques dudit signal de sortie système (110).

EP 1 645 028 B1

**FIG. 1**

**FIG. 2**

FIG. 3

EP 1 645 028 B1

FIG. 4

EP 1 645 028 B1

FIG. 5

FIG. 6

EP 1 645 028 B1

FIG. 7

EP 1 645 028 B1

FIG. 8

EP 1 645 028 B1

FIG. 9

EP 1 645 028 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6246286 B
- US 5990734 A
- WO 0108294 A
- US 10205743 B
- US 10272725 B